# EUROPEAN PATENT APPLICATION

(11) **EP 4 593 540 A2**
(43) Date of publication of application: **30.07.2025**
(21) Application number: 24223204.9
(22) Date of filing: 24.12.2024
(51) Int. Cl.: H05K 7/20

(54) **SYSTEMS AND METHODS FOR LIQUID COOLING OF MULTICOMPONENT PACKAGES**

(30) Priority: 23.01.2024 US 202418420364
(71) Applicant: Microsoft Technology Licensing, LLC, Redmond, WA 98052 (US)
(72) Inventor: ORTEGA GUTIERREZ, Felipe Enrique, Redmond, Washington (US); RAMAKRISHNAN, Bharath, Redmond, Washington (US); PETERSON, Eric Clarence, Redmond, Washington (US); ALISSA, Husam Atallah, Redmond, Washington (US)
(74) Representative: CMS Cameron McKenna Nabarro Olswang LLP

(57) **Abstract**

A device may include a body including: an internal volume configured to receive a working fluid, and an inner contact surface configured to transfer heat from a heat-generating component to the internal volume. A device may include a first zone of the internal volume including a first thermal management feature. A device may include a second zone of the internal volume including a second thermal management feature different from the first thermal management feature.

## Description

### BACKGROUND

Thermal management of electronic components has long been a limitation to computing performance. Electronic packages with a plurality of different electronic components on a shared substrate reduce latencies and improves performance, but presents a challenge to efficient thermal management.

### BRIEF SUMMARY

In some aspects, the techniques described herein relate to a thermal management device including: a body including: an internal volume configured to receive a working fluid, and an inner contact surface configured to transfer heat from a heat-generating component to the internal volume; a first zone of the internal volume including a first thermal management feature; and a second zone of the internal volume including a second thermal management feature different from the first thermal management feature.

In some aspects, the techniques described herein relate to a thermal management device including: a body including: an internal volume configured to receive a working fluid, at least one inlet to the internal volume, at least one outlet from the internal volume, a valve configured to change a working fluid flow in the internal volume, and an inner contact surface configured to transfer heat from a heat-generating component to the internal volume; a first zone of the internal volume including a first thermal management feature; and a second zone of the internal volume including a second thermal management feature different from the first thermal management feature.

In some aspects, the techniques described herein relate to a thermal management device including: a body including: an internal volume, a first inlet to a first portion of the internal volume configured to receive a first working fluid, a second inlet to a second portion of the internal volume configured to receive a second working fluid, a first outlet from the first portion of the internal volume, a second outlet from the second portion of the internal volume, and an inner contact surface configured to transfer heat from a heat-generating component to the internal volume; a first zone in the first portion of the internal volume including a first thermal management feature; and a second zone in the second portion of the internal volume including a second thermal management feature different from the first thermal management feature.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

Additional features and advantages will be set forth in the description which follows, and in part will be obvious from the description, or may be learned by the practice of the teachings herein. Features and advantages of the disclosure may be realized and obtained by means of the instruments and combinations particularly pointed out in the appended claims. Features of the present disclosure will become more fully apparent from the following description and appended claims or may be learned by the practice of the disclosure as set forth hereinafter.

### BRIEF DESCRIPTION OF THE DRAWINGS

In order to describe the manner in which the above-recited and other features of the disclosure can be obtained, a more particular description will be rendered by reference to specific embodiments thereof which are illustrated in the appended drawings. For better understanding, the like elements have been designated by like reference numbers throughout the various accompanying figures. While some of the drawings may be schematic or exaggerated representations of concepts, at least some of the drawings may be drawn to scale. Understanding that the drawings depict some example embodiments, the embodiments will be described and explained with additional specificity and detail through the use of the accompanying drawings in which:
FIG. 1 is a perspective partial cutaway view of a thermal management device coupled to an electronic package 102 with a plurality of heat-generating components, according to at least some embodiments of the present disclosure.
FIG. 2 is a partial cutaway perspective view of a thermal management device with a plurality of zones therein to provide different amounts of thermal management capacity, according to at least some embodiments of the present disclosure.
FIG. 3 is a partial cutaway perspective view of a thermal management device with different thermal management structures in different zones, according to at least some embodiments of the present disclosure.
FIG. 4-1 and FIG. 4-2 are top cross-sectional views of thermal management devices includes valves, according to at least some embodiments of the present disclosure.
FIG. 5 is a side cross-sectional view of a thermal management device including a nozzle, according to at least some embodiments of the present disclosure.
FIG. 6 is a side cross-sectional view of a thermal management device with direct cooling of a heat-generating component, according to at least some embodiments of the present disclosure.
FIG. 7 is a thermal management device with an internal volume divided into at least a first portion and a second portion, according to at least some embodiments of the present disclosure.
FIG. 8 is a flow diagram of a thermal management device including discrete fluid loops, according to at least some embodiments of the present disclosure.

### DETAILED DESCRIPTION

The present disclosure relates generally to systems and methods for cooling computing components. More particularly, the present disclosure relates to liquid cooling of computing packages and components with a plurality of dies or other electronics components on a single silicon substrate. In some embodiments, silicon developers continue to evolve chip applications, and there is a need to centralize different functions of the silicon into closer spaces. In some embodiments, the evolution of chip design converts a conventional single die into multiple dies and converts the dies from one size to multiple sizes and stacks, each of which may have different heat fluxes, temperature requirements, and resiliency.

While multi-die computing packages can be more efficient and/or more powerful, thermal management of multi-die computing packages can present a challenge. For example, a package design with a plurality of computing components and/or dies close to one another can reduce latency therebetween but also limits the available space for conventional cold plates and other thermal management devices to be affixed to each die or component individually. Similarly, a thermal management device that is positioned across or in contact with a plurality of dies with different thermal management requirements can create inefficiencies in the thermal management device.

In some embodiments, a thermal management device that is positioned in contact with a first die and a second die provides the same thermal management capacity (e.g., thermal transfer flux) from the first die and the second die. In some examples, the first die produces more heat than the second die. To ensure the first die is sufficiently cooled by the thermal management device, the thermal management capacity of the entire thermal management device is increased to meet the needs of the first die. This can result in a thermal management device with a thermal management capacity unnecessarily large for the second die.

In some embodiments, according to the present disclosure, a thermal management device has an internal volume with a working fluid flowing therethrough. The internal volume has a first zone and a second zone that have different thermal management capacities. For example, the first zone may have a first thermal transfer rate from a first contact surface to the working fluid of the first zone that is greater than a second thermal transfer rate from a second contact surface to the working fluid of the second zone. In some embodiments, the first thermal transfer rate and the second thermal transfer rate are different based at least partially on different thermal management features located in the first zone and the second zone. In some embodiments, the first thermal transfer rate and the second thermal transfer rate are different based at least partially on different flow rates of the working fluid through the zones of the internal volume. In some embodiments, the first thermal transfer rate and the second thermal transfer rate are different based at least partially on different working fluids in each of the first zone and second zone. In some embodiments, the first thermal transfer rate and the second thermal transfer rate are different based at least partially on different volumes of working fluid in each of the first zone and second zone. In some embodiments, the first thermal transfer rate and the second thermal transfer rate are different based at least partially on different temperatures of the working fluid in each of the first zone and second zone.

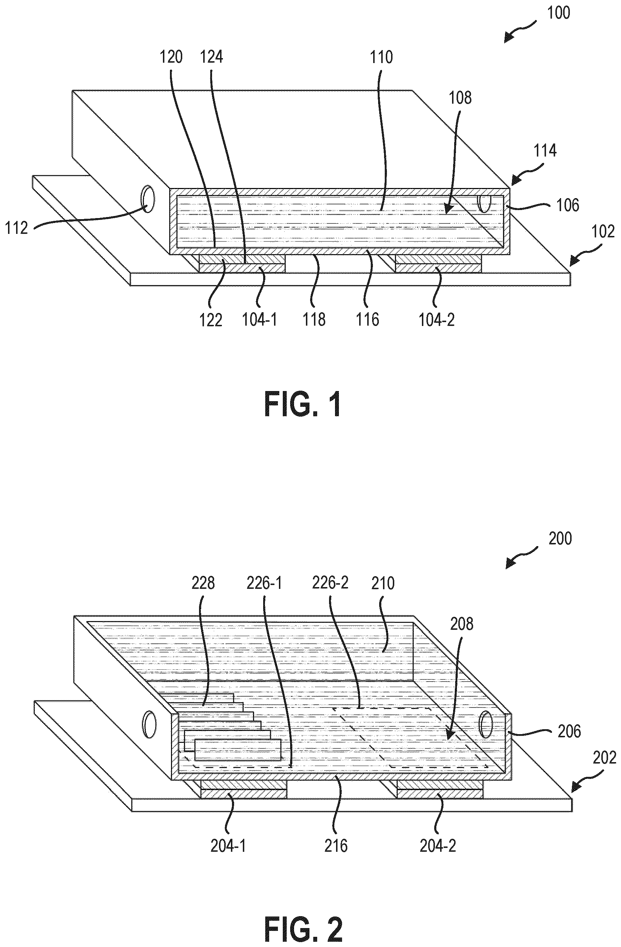

FIG. 1 is a perspective partial cutaway view of an embodiment of a thermal management device 100 coupled to an electronic package 102 with a plurality of heat-generating components 104-1, 104-2. In some embodiments, a thermal management device 100 includes a body 106 that defines an internal volume 108. The internal volume 108 receives and contains a working fluid 110 therein. In some embodiments, the working fluid is a single-phase working fluid. In some example, the single-phase working fluid flows into the internal volume 108 of the body 106 through an inlet 112 in the body 106 and out of the internal volume 108 through an outlet 114 in the body 106. The thermal management device 100 is thermally-coupled to a plurality of heat-generating components 104-1, 104-2 of an electronic package 102. For example, the electronic package may include a first die and a second die. The first die and the second die may generate different quantities of heat during operation. In at least one example, the first die is a processing unit, and the second die is a memory device. During operation of the electronic package 102, the processing unit generates more heat than the memory device and, therefore, the processing unit requires more thermal management capacity proximate the processing unit than the memory device.

In some embodiments, the processor(s) is a central processing unit that performs general computing tasks for the computing device. In some embodiments, the processor(s) is a graphics processing unit. In some embodiments, the processor(s) is or is part of a system on chip (SoC) or application specific integrated circuit (ASIC) that is dedicated to controlling or communicating with one or more subsystems of a computing device.

In some embodiments, a memory device is a non-transient storage device including any of RAM, ROM, EEPROM, CD-ROM or other optical disk storage (such as CDs, DVDs, etc.), magnetic disk storage or other magnetic storage devices, or any other medium which can be used to store desired program code means in the form of computer-executable instructions or data structures and which can be accessed by a general purpose or special purpose computer.

In some embodiments, a component or die of the electronic package is or includes other heat-generating computing or electronic components including, but not limited to, input/output connectors, network devices, optical connectors, photonic devices (light emitters and/or light detectors), or other heat-generating components.

The working fluid 110 receives heat from a heat-generating component 104-1, 104-2. A single-phase working fluid 110 receives heat, increasing in temperature, before exiting the internal volume 108 at the outlet 114 of the body 106. In some embodiments, the single-phase working fluid exhausts the received heat at a heat exchanger or other device to remove the heat to another heat sink or to the ambient atmosphere. The cooled single-phase working fluid 110 is, in some embodiments, returned to the internal volume 108 through an inlet 112 in the body 106 to receive heat from the heat-generating components 104-1, 104-2, again.

In some embodiments, the working fluid is a dual-phase working fluid. In such examples, the working fluid receives heat to change physical phase (e.g., from a liquid to a gas phase) without substantially changing in temperature. In some embodiments, the gas phase working fluid exits from the internal volume of the body to a condenser and/or compressor to remove heat from the gas phase working fluid and return the gas phase working fluid to a liquid phase (e.g., condensate). The condenser and/or compressor may exhaust the heat to another heat sink or to the ambient atmosphere. The liquid phase working fluid is, in some embodiments, returned to the internal volume through an inlet in the body to receive heat from the heat-generating components, again.

In some embodiments, a dual-phase working fluid has a boiling temperature below a critical temperature at which the heat-generating components experience thermal damage. The working fluid can thereby receive heat from the heat-generating components to cool the heat-generating components before the heat-generating components experience damage.

For example, the heat-generating components may be computing components that experience damage above 100° Celsius (C). In some embodiments, the boiling temperature of the working fluid is less than a critical temperature of the heat-generating components. In some embodiments, the boiling temperature of the working fluid is less about 90° C at 1 atmosphere of pressure. In some embodiments, the boiling temperature of the working fluid is less about 80° C at 1 atmosphere of pressure. In some embodiments, the boiling temperature of the working fluid is less about 70° C at 1 atmosphere of pressure. In some embodiments, the boiling temperature of the working fluid is less about 60° C at 1 atmosphere of pressure. In some embodiments, the boiling temperature of the working fluid is at least about 35° C at 1 atmosphere of pressure. In some embodiments, the working fluid includes water.

In some embodiments, the working fluid includes glycol. In some embodiments, the working fluid includes a combination of water and glycol. In some embodiments, the working fluid includes an aqueous solution. In some embodiments, the working fluid includes an electronic liquid, such as FC-72 available from 3M, or similar non-conductive fluids.

In some embodiments, the body 106 of the thermal management device 100 has a contact wall 116 with an outer contact surface 118 on an external side of the contact wall 116 (e.g., opposite the internal volume 108 ) and an inner contact surface 120 on an internal side of the contact wall 116 (e.g., proximate to the internal volume 108). In some embodiments, the contact wall 116 is a continuous heat spreader. For example, the contact wall 116 includes a thermally conductive material that spreads heat received from the heat-generating components 104-1, 104-2 of the electronic package 102 within the plane of the heat spreader. In some embodiments, the heat spreader includes a vapor chamber or other volume including a vapor chamber working fluid that moves heat within the plane of the heat spreader.

It should be understood that thermally coupled components have a thermally conductive path therebetween, but the components need not be in direct contact with one another. In some embodiments, the contact wall 116 is thermally coupled to the heat-generating components 104-1, 104-2 of the electronic package 102 through a thermal interface material (TIM) 122. For example, the TIM 122 may be or include a gel, paste, or compressible solid that conforms to the top surface 124 of the heat-generating components 104-1, 104-2 and the outer contact surface 118 of the body 106 to limit and/or prevent gaps in the thermal coupling. In at least one example, the TIM 122 is or includes a metallic paste through which heat can move from the heat-generating component(s) 104-1, 104-2 to the contact wall 116 of the body 106 and into the working fluid 110 in the internal volume 108 of the body 106. The working fluid 110 is, therefore, thermally coupled to the heat-generating component(s) 104-1, 104-2 to receive heat therefrom.

In some embodiments, the contact wall 116 of the body 106 proximate to the heat-generating component(s) 104-1, 104-2 is planar and has a uniform thickness across the contact wall 116 (e.g., from the outer contact surface 118 to the inner contact surface 120). In some embodiments, at least a portion of the contact wall 116 is non-planar. In some examples, a non-planar outer contact surface 118 of contact wall 116 of the body 106 is configured to accommodate topography of the different heat-generating components 104-1, 104-2 of the electronic package 102. For example, a first die and a second die have different heights above a substrate of the electronic package, and the outer contact surface of the contact wall is non-planar to accommodate the different heights of the dies while the body is relatively co-planar with the substrate of the electronic package.

In some embodiments, the contact wall 116 has a non-planar inner contact surface 120 that is substantially complementary to the outer contact surface 118 to maintain a constant thickness of the contact wall 116. In some embodiments, a non-constant thickness of the contact wall 116 maintains a planar inner contact surface 120 of the contact wall 116 while the outer contact surface 118 accommodates the varying topography of the heat-generating components 104-1, 104-2 of the electronic package 102. While some embodiments of thermal management features in or on the thermal management device are described in relation to a planar contact wall and contact surfaces thereof, it should be understood than any thermal management feature described herein is useable with a contact wall or contact surface that is at least partially non-planar.

FIG. 2 is a partial cutaway perspective view of an embodiment of a thermal management device 200 with a plurality of zones 226-1, 226-2 therein to provide different amounts of thermal management capacity. As described herein, different heat-generating components 204-1 204-2 of an electronic package 202 may generate different amounts of heat, different heatfluxes, or otherwise require different amounts of thermal management from the thermal management device 200 thermally coupled thereto. In some embodiments, a thermal management device 200 includes one or more thermal management features in an internal volume 208 to promote heat transfer to the working fluid 210. In some embodiments, different thermal management features in different zones 226-1, 226-2 of the internal volume 208 provide different rates of heat transfer in the different zones 226-1, 226-2. The zones 226-1, 226-2, in some embodiments, are proximate to and/or overlap the portion of the contact wall 216 in contact with or thermally coupled to the heat-generating components 204-1, 204-2 of the electronic package 202.

In some embodiments, the zones 226-1, 226-2 are defined by the location of the thermal management features. For example, a first zone 226-1 includes thermal transfer structures 228, such as thermal fins, thermal pins, or other surface features that increase the surface area of the contact wall with the working fluid. The thermal transfer structures 228 increase the thermal transfer rate of heat from the contact wall 216 to the working fluid 210 in the first zone 226-1 relative to a second zone 226-2 of the contact wall 216 that lack the thermal transfer structures or have different thermal transfer structures and/or thermal management features.

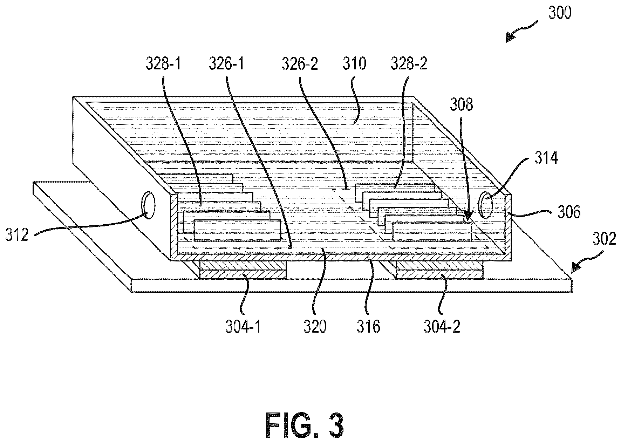

FIG. 3 is a partial cutaway perspective view of an embodiment of a thermal management device 300 with different thermal management structures 328-1, 328-2 in different zones 326-1, 326-2. In some embodiments, a second zone 326-2 has second thermal transfer structures 328-2 that have less surface area in contact with the working fluid 310. The second zone 326-2, therefore, has a lower thermal transfer rate (relative to an equivalent temperature difference between the contact wall and the working fluid) than the first zone 326-1. The first zone 326-1, in such an embodiment, has a greater thermal management capacity than the second zone 326-2 using the same working fluid 310 in the same internal volume 308 when in fluid parallel with the second zone 326-2.

In some embodiments, the first zone 326-1 has first thermal transfer structures 328-1 with a greater density than the second thermal transfer structures 328-2 of the second zone 326-2. For example, the first zone 326-1 may have more fins, pins, or other thermal transfer structures 328-1 per unit area (e.g., square-centimeter, square-millimeter) than the second zone 326-2. In some embodiments, the first thermal transfer structures 328-1 of the first zone 326-1 may have a greater surface area to volume ratio than the second thermal transfer structures 328-2 of the second zone 326-2. For example, the first zone 326-1 may have thinner pin fins than the second zone 328-2. In some embodiments, the first thermal transfer structures 328-1 of the first zone 326-1 may have a greater height in the internal volume 308 relative to the inner contact surface 320 than the second thermal transfer structures 328-2 of the second zone 326-2. For example, the first zone 326-1 may have taller pin fins than the second zone 326-2.

In some embodiments, the contact wall 316 includes a heat spreader proximate to a first heat-generating component 304-1 of the electronic package 302 that spreads the heat received from the first heat-generating component 304-1 over a larger area than the area of the first heat-generating component 304-1. The first zone of the thermal management device may be larger than the first heat-generating component, therefore, allowing the heat to be dissipated over a larger area than that of the first heat-generating component 304-1. In some embodiments, the first zone 326-1 includes the heat spreader of the contact wall 316 and a second zone 326-2 lacks a heat spreader or has heat spreader with a lower thermal conductivity (or lower thermal transfer rate) in the plane of the contact wall 316. The second zone 326-2, therefore, has less area and/or less thermal transfer features 328-2 over which to distribute and dissipate the heat, and the first zone 326-1 has a greater thermal management capacity.

The thermal management capacity, in some embodiments, changes relative to a flow direction of the working fluid 310 through the internal volume 308. For example, a first heat-generating component 304-1 may require greater thermal management capacity than a second heat-generating component 304-2. As illustrated in the embodiment of FIG. 3, the first zone 326-1 (proximate to the first heat-generating component 304-1) is, in some embodiments, positioned in fluid series before the second zone 326-2 (proximate to the second heat-generating component 304-2) relative to the flow direction of the working fluid 310. For example, the first zone 326-1 may be closer to the fluid inlet 312 of the internal volume 308, and the second zone 326-2 may be closer to the fluid outlet 314 of the internal volume 308 when in fluid series with the first zone 326-1. The working fluid 310 is, in some embodiments, cooler in the first zone 326-1 than in the second zone 326-2 when in fluid series. In such an example, the thermal transfer rate between the inner contact surface 320 and/or first thermal transfer features 328-1 of the first zone 326-1 and the cooler working fluid 310 is greater than the thermal transfer rate between the inner contact surface 320 and/or second thermal transfer features 328-2 of the second zone 326-2 and the warmer working fluid.

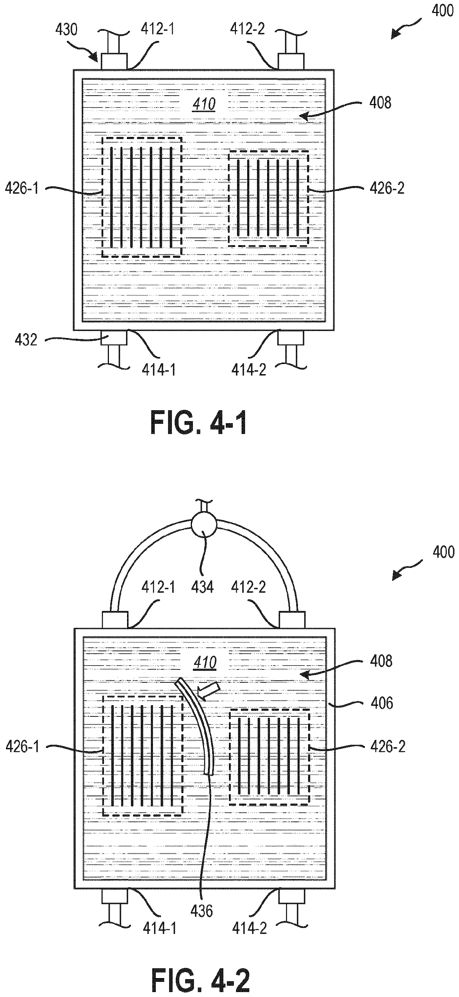

Referring now to FIG. 4-1 and FIG. 4-2, in some embodiments, the thermal management device 100 includes one or more mechanisms to change the flowrate(s) and/or flow volume(s) of working fluid 410 through the first zone 426-1 and the second zone 426-2 of the internal volume 408 . For example, the thermal management device 400 includes a first inlet 412-1 proximate to a first zone 426-1 and a second inlet 412-2 proximate to a second zone 426-2. The thermal management device includes an inlet valve 430 on at least one of the first inlet 412-1 and the second inlet 412-2 to change the relative to flowrate and/or flow volume of working fluid 410 through the inlets into the internal volume 408. For example, opening the inlet valve 430 on the first inlet 412-1 proximate to the first zone 426-1 may result in an increased first flowrate and/or flow volume through the first zone 426-1 relative to a second flowrate and/or flow volume through the second zone 426-2.

In some embodiments, the thermal management device includes a first outlet 414-1 proximate to a first zone 426-1 and a second outlet 414-2 proximate to a second zone 426-2. The thermal management device 400 includes an outlet valve 432 on at least one of the first outlet 414-1 and the second outlet 414-2 to change the relative to flowrate and/or flow volume of working fluid 410 through the outlet out of the internal volume 408. For example, opening the outlet valve 432 on the first outlet 414-1 proximate to the first zone 426-1 may result in an increased first flowrate and/or flow volume through the first zone 426-1 relative to a second flowrate and/or flow volume through the second zone 426-2. In some embodiments, the thermal management device 400 includes valves 430, 432 on at least one inlet and at least one outlet to change the flowrate(s) and/or flow volume(s) of working fluid through the first zone 426-1 and the second zone 426-2 of the internal volume 408.

The thermal management device 400 , in some embodiments, includes one or more mechanisms to change the relative flowrate(s) and/or flow volume(s) through the first zone 426-1 and the second zone 426-2 without changing a net flow through the internal volume 408 (i.e., net flow through the inlet(s) 412-1, 412-2 and through the outlet(s) 414-1, 414-2). Referring now to FIG. 4-2, in some embodiments, the thermal management device includes a proportioning device, such as a proportional three-way valve 434, that diverts a variable proportion of the working fluid flow toward the first zone 426-1 and the second zone 426-2. For example, a proportioning device positioned before the inlets 412-1, 412-2 relative to the flow direction can selectively control a ratio of working fluid flow through the first inlet 412-1 and through the second inlet 412-2. In some examples, a proportioning device positioned after the outlets 414-1, 414-2 relative to the flow direction can selectively control a ratio of working fluid flow through the first outlet 414-1 and through the second outlet 414-2 toward a heat exchanger or other heat exhaust device.

In some embodiments, a proportioning device is positioned at least partially inside the interval volume 408. A proportioning valve in the internal volume 408 may direct a portion of the working fluid flow toward or away from the first zone 426-1 and/or second zone 426-2. In some embodiments, the proportioning valve is a passive valve, such as a bi-metal valve 436 (or other combination of materials) that changes position passively in response to a temperature of the working fluid 410, the first zone 426-1, the second zone 426-2, another portion of the thermal management device body 406, or combinations thereof. In a particular example, the first heat-generating component of the electronic package is a central processing unit (CPU), and the second heat-generating component of the electronic package is a graphics processing unit (GPU).

Depending on the computational task the CPU and GPU may experience different loads and generate different amounts of heat. During a GPU-intensive computational task, the second zone 426-2 of the thermal management device experiences an increased quantity of heat and/or increased temperature. A difference in the coefficient of the thermal expansion (CTE) between materials in the proportioning valve causes at least a portion of the valve to move laterally when the temperature of the materials changes. The lateral movement of at least a portion of the valve changes the working fluid flow in the internal volume 408. In some embodiments, the valve moves to direct a greater proportion of the working fluid flow through the second zone 426-2 when the valve increases in temperature due to the increase in temperature of the second zone 426-2.

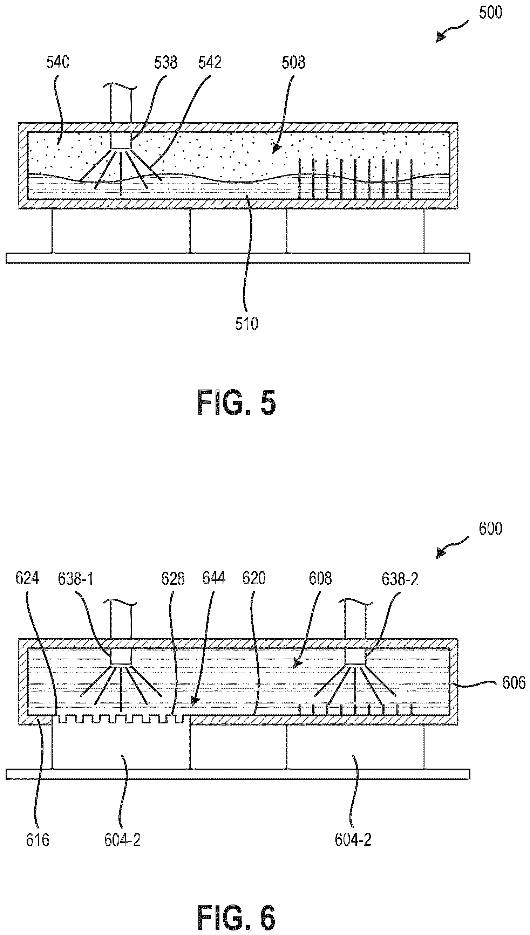

In some embodiments, a thermal management feature is an active feature, such as a jet nozzle or spray nozzle illustrated in the embodiment of FIG. 5 that directs working fluid flow toward or directly impinging upon the contact wall or a contact surface of the internal volume. In some embodiments, a jet nozzle or spray nozzle 538 directs working fluid flow toward or directly impinging upon any of the thermal transfer structures 528 described herein. In some embodiments, the jet nozzle directs liquid phase working fluid into liquid phase working fluid 510 to direct fluid flow through the internal volume 508. In some embodiments, a jet nozzle or spray nozzle directs liquid phase working fluid 510 into a portion of the internal volume 508 including a gas 540 (e.g., a gas phase working fluid or inert gas).

For example, the internal volume 508 of the thermal management device 500 may include a headspace of gas 540 that allows space for the vaporization of a dual-phase working fluid 510. A spray nozzle 538, in some embodiments, disperses a plurality of droplets 542 of liquid working fluid 510 through the gas phase 540 to transfer heat between the gas 540 and the droplets 542. In some embodiments, the plurality of droplets 542 directly impinge upon a contact wall 516 or an inner contact surface 520 of the internal volume 508 to receive heat from the contact wall 516 or contact surface. In some embodiments, plurality of droplets 542 directly impinge upon one or more thermal transfer structures 528, such as pin fins, described herein to receive heat from the thermal transfer structures 528.

FIG. 6 is a side cross-sectional view of another embodiment of a thermal management device 600. In some embodiments, the internal volume 608 is at least partially defined by a top surface 624 of a heat-generating component. For example, the body 606 of the thermal management device 600 may include a window 644 or other opening in a contact wall 616 that complementarily mates with the heat-generating component 604-1 such that a top surface 624 of the heat-generating component 604-1 is at least a portion of an inner contact surface 620 of the internal volume 608. In some embodiments, the working fluid 610 in the internal volume 608 is positioned in direct contact with the top surface 624 of the heat-generating component 604-1. Direct contact between the top surface 624 and the working fluid 610 removes interfaces relative to a conventional thermal management device and may increase thermal transfer efficiency between the heat-generating component and the working fluid.

In some embodiments, the jet nozzles and/or spray nozzles have different nozzle velocity and/or nozzle flow volumes. For example, direct impingement of a fluid jet from a jet nozzle 638-1, 638-2 can erode a top surface of a heat-generating component, while the same fluid jet of working fluid erodes a contact wall 616 of the body 606 of the thermal management device 600 at a different rate. In at least one embodiment, a first nozzle 638-1 and a second nozzle 638-2 have the same flow volume therethrough (e.g., milliliters per minute) while the first nozzle 638-1 has a different flow velocity of the working fluid 610 than the second nozzle 638-2. The mass of working fluid able to receive heat from the heat-generating component may be substantially equal, while the difference in flow velocity reduces the erosion relative to a faster flow velocity.

As described herein, the jet nozzle and/or spray nozzle, in some embodiments, directs working fluid flow toward a top surface 624 of a heat-generating component, and, in some embodiments, directs working fluid flow at a thermal transfer structure 628 of the thermal management device. In some embodiments, the heat-generating component 604-1 has thermal transfer structures 628 integrally formed with the top surface 624 to increase a surface area of the top surface 624.

In some examples, a thermal transfer structure 628 is integrally formed with the top surface 624 by additive manufacturing. For example, one or more pins, fins, or other thermal transfer structures may be formed through the application and/or epitaxial growth of material on a top surface of the heat-generating component. In some embodiments, at least a portion of a thermal transfer structure is above a portion of the top surface of the heat-generating component. In some examples, a thermal transfer structure 628 is integrally formed with the top surface 624 by substrative manufacturing. For example, one or more pins, fins, or other thermal transfer structures may be formed through the removal of material from the top surface of the heat-generating component such as by machining, ion etching, chemical etching, or other removal techniques to create channels, recesses, or voids in the top surface. In some embodiments, at least a portion of a thermal transfer structure is above a below of the top surface of the heat-generating component.

In at least one embodiment, a thermal management device according to the present disclosure has a hybrid design with direct contact between working fluid and a top surface of at least one heat-generating component 604-1 in a first zone while a contact wall 616 (and, optionally, TIM) thermally couples a second heat-generating component 604-2 to a second zone.

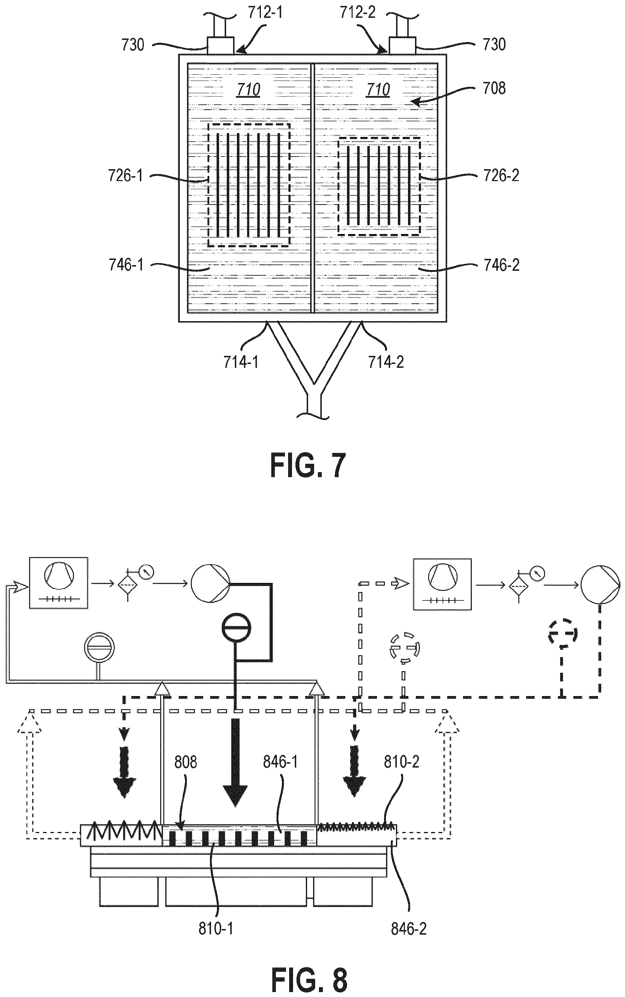

While embodiments of thermal management devices have been described herein with a working fluid in an internal volume, in some embodiments, such as that illustrated in FIG. 7, the internal volume 708 is divided into at least a first portion 746-1 and a second portion 746-2. The first portion 746-1 of the internal volume 708 and second portion 746-2 of the internal volume 708 are discrete fluid volumes between which a first portion of the working fluid 710 in the first portion 746-1 of the internal volume 708 does not enter the second portion 746-2 of the internal volume 708, and vice versa. In some embodiments, the first portion 746-1 and second portion 746-2 share the working fluid 710 that circulates through the thermal management device 700. For example, the first portion of the working fluid 710 enters the first portion 746-1 of the internal volume 708 through a first inlet 712-1 and exits the first portion 746-1 of the internal volume 708 through a first outlet 714-1, while the second portion of the working fluid 710 enters the second portion 746-2 of the internal volume 708 through a second inlet 712-2 and exits the second portion 746-2 of the internal volume 708 through a second outlet 714-2. In some embodiments, a valve 730 on one or more of the inlets and/or outlets can allow the adjustments to the flowrates and/or flow volumes through the first portion 746-1 and second portion 746-2 of the internal volume 708.

In some embodiments, the first outlet 714-1 is connected to a heat exchanger, condenser, compressor, or other device for exhausting heat from the working fluid 710, and the second outlet 714-2 is connected to the same heat exchanger, condenser, compressor, or other device for exhausting heat from the working fluid 710. The working fluid then circulates from the heat exchanger, condenser, compressor, or other device for exhausting heat from the working fluid 710 to the inlets 712-1, 712-2.

Referring now to FIG. 8, in some embodiments, the first portion 846-1 of the internal volume 808 and the second portion 846-2 of the internal volume 808 of the thermal management device 800 are part of discrete fluid loops, in which a first working fluid 810-1 of the first portion 846-1 and a second working fluid 810-2 of the second portion 846-2 are not shared and/or do not mix inside the internal volume 808 or at any other point. For example, the heat-generating components 804-1, 804-2 of the electronic package may have different maximum temperatures, and different working fluids are appropriate for the temperatures experienced in the first zone (associated with a first heat-generating component) in the first portion 846-1 and for the temperatures experienced in the second zone (associated with a second heat-generating component) in the second portion 846-2.

Discrete fluid loops can allow for different working fluids, such as a single-phase working fluid in the first zone and a dual-phase working fluid in the second zone. In some embodiments, the first working fluid has a higher viscosity, limiting the ability of the first working fluid to flow through spray nozzles, while a second working fluid has a low viscosity, allowing the second working fluid to be sprayed through a spray nozzle. In some embodiments, the first zone includes a top surface of the heat-generating component, which is susceptible to reaction with a particular solvent, and a second working fluid used in the second zone (which is bounded by the contact wall) includes the solvent.

### INDUSTRIAL APPLICABILITY

The present disclosure relates generally to systems and methods for cooling computing components. More particularly, the present disclosure relates to liquid cooling of computing packages and components with a plurality of dies or other electronics components on a single silicon substrate. In some embodiments, silicon developers continue to evolve chip applications, and there is a need to centralize different functions of the silicon into closer spaces. In some embodiments, the evolution of chip design converts a conventional single die into multiple dies and converts the dies from one size to multiple sizes and stacks, each of which may have different heat fluxes, temperature requirements, and resiliency.

While multi-die computing packages can be more efficient and/or more powerful, thermal management of multi-die computing packages can present a challenge. For example, a package design with a plurality of computing components and/or dies close to one another can reduce latency therebetween but also limits the available space for conventional cold plates and other thermal management devices to be affixed to each die or component individually. Similarly, a thermal management device that is positioned across or in contact with a plurality of dies with different thermal management requirements can create inefficiencies in the thermal management device.

In some embodiments, a thermal management device that is positioned in contact with a first die and a second die provides the same thermal management capacity (e.g., thermal transfer flux) from the first die and the second die. In some examples, the first die produces more heat than the second die. To ensure the first die is sufficiently cooled by the thermal management device, the thermal management capacity of the entire thermal management device is increased to meet the needs of the first die. This can result in a thermal management device with a thermal management capacity unnecessarily large for the second die.

In some embodiments, according to the present disclosure, a thermal management device has an internal volume with a working fluid flowing therethrough. The internal volume has a first zone and a second zone that have different thermal management capacities. For example, the first zone may have a first thermal transfer rate from a first contact surface to the working fluid of the first zone that is greater than a second thermal transfer rate from a second contact surface to the working fluid of the second zone. In some embodiments, the first thermal transfer rate and the second thermal transfer rate are different based at least partially on different thermal management features located in the first zone and the second zone. In some embodiments, the first thermal transfer rate and the second thermal transfer rate are different based at least partially on different flow rates of the working fluid through the zones of the internal volume. In some embodiments, the first thermal transfer rate and the second thermal transfer rate are different based at least partially on different working fluids in each of the first zone and second zone. In some embodiments, the first thermal transfer rate and the second thermal transfer rate are different based at least partially on different volumes of working fluid in each of the first zone and second zone. In some embodiments, the first thermal transfer rate and the second thermal transfer rate are different based at least partially on different temperatures of the working fluid in each of the first zone and second zone.

In some embodiments, a thermal management device includes a body that defines an internal volume. The internal volume receives and contains a working fluid therein. In some embodiments, the working fluid is a single-phase working fluid. In some example, the single-phase working fluid flows into the internal volume of the body through an inlet in the body and out of the internal volume through an outlet in the body. The thermal management device is thermally-coupled to a plurality of heat-generating components of an electronic package. For example, the electronic package may include a first die and a second die. The first die and the second die may generate different quantities of heat during operation. In at least one example, the first die is a processing unit, and the second die is a memory device. During operation of the electronic package, the processing unit generates more heat than the memory device and, therefore, the processing unit requires more thermal management capacity proximate the processing unit than the memory device.

In some embodiments, the processor(s) is a central processing unit that performs general computing tasks for the computing device. In some embodiments, the processor(s) is a graphics processing unit. In some embodiments, the processor(s) is or is part of a system on chip (SoC) or application specific integrated circuit (ASIC) that is dedicated to controlling or communicating with one or more subsystems of a computing device.

In some embodiments, a memory device is a non-transient storage device including any of RAM, ROM, EEPROM, CD-ROM or other optical disk storage (such as CDs, DVDs, etc.), magnetic disk storage or other magnetic storage devices, or any other medium which can be used to store desired program code means in the form of computer-executable instructions or data structures and which can be accessed by a general purpose or special purpose computer.

In some embodiments, a die of the electronic package is or includes other heat-generating computing or electronic components including, but not limited to, input/output connectors, network devices, optical connectors, photonic devices (light emitters and/or light detectors), or other heat-generating components.

The working fluid receives heat from a heat-generating component. A single-phase working fluid receives heat, increasing in temperature, before exiting the internal volume at the outlet of the body. In some embodiments, the single-phase working fluid exhausts the received heat at a heat exchanger or other device to remove the heat to another heat sink or to the ambient atmosphere. The cooled single-phase working fluid is, in some embodiments, returned to the internal volume through an inlet in the body to receive heat from the heat-generating components, again.

In some embodiments, the working fluid is a dual-phase working fluid. In such examples, the working fluid receives heat to change physical phase (e.g., from a liquid to a gas phase) without substantially changing in temperature. In some embodiments, the gas phase working fluid exits from the internal volume of the body to a condenser and/or compressor to remove heat from the gas phase working fluid and return the gas phase working fluid to a liquid phase (e.g., condensate). The condenser and/or compressor may exhaust the heat to another heat sink or to the ambient atmosphere. The liquid phase working fluid is, in some embodiments, returned to the internal volume through an inlet in the body to receive heat from the heat-generating components, again.

In some embodiments, a dual-phase working fluid has a boiling temperature below a critical temperature at which the heat-generating components experience thermal damage. The working fluid can thereby receive heat from the heat-generating components to cool the heat-generating components before the heat-generating components experience damage.

For example, the heat-generating components may be computing components that experience damage above 100° Celsius (C). In some embodiments, the boiling temperature of the working fluid is less than a critical temperature of the heat-generating components. In some embodiments, the boiling temperature of the working fluid is less about 90° C at 1 atmosphere of pressure. In some embodiments, the boiling temperature of the working fluid is less about 80° C at 1 atmosphere of pressure. In some embodiments, the boiling temperature of the working fluid is less about 70° C at 1 atmosphere of pressure. In some embodiments, the boiling temperature of the working fluid is less about 60° C at 1 atmosphere of pressure. In some embodiments, the boiling temperature of the working fluid is at least about 35° C at 1 atmosphere of pressure. In some embodiments, the working fluid includes water.

In some embodiments, the working fluid includes glycol. In some embodiments, the working fluid includes a combination of water and glycol. In some embodiments, the working fluid includes an aqueous solution. In some embodiments, the working fluid includes an electronic liquid, such as FC-72 available from 3M, or similar non-conductive fluids.

In some embodiments, the body of the thermal management device has a contact wall with an outer contact surface on an external side of the contact wall (e.g., opposite the internal volume) and an inner contact surface on an internal side of the contact wall (e.g., proximate to the internal volume). In some embodiments, the contact wall is a continuous heat spreader. For example, the contact wall includes a thermally conductive material that spreads heat received from the heat-generating components of the electronic package within the plane of the heat spreader. In some embodiments, the heat spreader includes a vapor chamber or other volume including a vapor chamber working fluid that moves heat within the plane of the heat spreader.

It should be understood that thermally coupled components have a thermally conductive path therebetween, but the components need not be in direct contact with one another. In some embodiments, the contact wall is thermally coupled to the heat-generating components of the electronic package through a thermal interface material (TIM). For example, the TIM may be or include a gel, paste, or compressible solid that conforms to the top surface of the heat-generating components and the outer contact surface of the body to limit and/or prevent gaps in the thermal coupling. In at least one example, the TIM is or includes a metallic paste through which heat can move from the heat-generating component(s) to the contact wall of the body and into the working fluid in the internal volume of the body. The working fluid is, therefore, thermally coupled to the heat-generating component(s) to receive heat therefrom.

In some embodiments, the contact wall of the body proximate to the heat-generating component(s) is planar and has a uniform thickness across the contact wall (e.g., from the outer contact surface to the inner contact surface). In some embodiments, at least a portion of the contact wall is non-planar. In some examples, a non-planar outer contact surface of contact wall of the body is configured to accommodate topography of the different heat-generating components of the electronic package. For example, a first die and a second die have different heights above a substrate of the electronic package, and the outer contact surface of the contact wall is non-planar to accommodate the different heights of the dies while the body is relatively co-planar with the substrate of the electronic package.

In some embodiments, the contact wall has a non-planar inner contact surface that is substantially complementary to the outer contact surface to maintain a constant thickness of the contact wall. In some embodiments, a non-constant thickness of the contact wall maintains a planar inner contact surface of the contact wall while the outer contact surface accommodates the varying topography of the heat-generating components of the electronic package. While some embodiments of thermal management features in or on the thermal management device are described in relation to a planar contact wall and contact surfaces thereof, it should be understood than any thermal management feature described herein is useable with a contact wall or contact surface that is at least partially non-planar.

As described herein, different heat-generating components of an electronic package may generate different amounts of heat, different heatfluxes, or otherwise require different amounts of thermal management from the thermal management device thermally coupled thereto. In some embodiments, a thermal management device includes one or more thermal management features in an internal volume to promote heat transfer to the working fluid. In some embodiments, different thermal management features in different zones of the internal volume provide different rates of heat transfer in the different zones. The zones, in some embodiments, are proximate to and/or overlap the portion of the contact wall in contact with or thermally coupled to the heat-generating components of the electronic package.

In some embodiments, the zones are defined by the location of the thermal management features. For example, a first zone includes thermal transfer structures, such as thermal fins, thermal pins, or other surface features that increase the surface area of the contact wall with the working fluid. The thermal transfer structures increase the thermal transfer rate of heat from the contact wall to the working fluid in the first zone relative to a second zone of the contact wall that lack the thermal transfer structures.

In some embodiments, a second zone has second thermal transfer structures that have less surface area in contact with the working fluid. The second zone, therefore, has a lower thermal transfer rate (relative to an equivalent temperature difference between the contact wall and the working fluid) than the first zone. The first zone, in such an embodiment, has a greater thermal management capacity than the second zone using the same working fluid in the same internal volume in fluid parallel with the second zone.

In some embodiments, the first zone has first thermal transfer structures with a greater density than the second thermal transfer structures of the second zone. For example, the first zone may have more fins, pins, or other thermal transfer structures per unit area (e.g., square-centimeter, square-millimeter) than the second zone. In some embodiments, the first thermal transfer structures of the first zone may have a greater surface area to volume ratio than the second thermal transfer structures of the second zone. For example, the first zone may have thinner pin fins than the second zone. In some embodiments, the first thermal transfer structures of the first zone may have a greater height in the internal volume relative to the inner contact surface than the second thermal transfer structures of the second zone. For example, the first zone may have taller pin fins than the second zone.

In some embodiments, the contact wall includes a heat spreader proximate to a first heat-generating component that spreads the heat received from the first heat-generating component over a larger area than the area of the first heat-generating component. The first zone of the thermal management device may be larger than the first heat-generating component, therefore, allowing the heat to be dissipated over a larger area than that of the first heat-generating component. In some embodiments, the first zone includes the heat spreader of the contact wall and a second zone lacks a heat spreader or has heat spreader with a lower thermal conductivity (or lower thermal transfer rate) in the plane of the contact wall. The second zone, therefore, has less area and/or less thermal transfer features over which to distribute and dissipate the heat, and the first zone has a greater thermal management capacity.

The thermal management capacity, in some embodiments, changes relative to a flow direction of the working fluid through the internal volume. For example, a first heat-generating component may require greater thermal management capacity than a second heat-generating component. The first zone (proximate to the first heat-generating component) is, in some embodiments, positioned before the second zone (proximate to the second heat-generating component) in fluid series relative to the flow direction of the working fluid. For example, the first zone may be closer to the fluid inlet of the internal volume, and the second zone may be closer to the fluid outlet of the internal volume when in fluid series. The working fluid is, in some embodiments, cooler in the first zone than in the second zone when in fluid series. In such an example, the thermal transfer rate between the inner contact surface and/or first thermal transfer features of the first zone and the cooler working fluid is greater than the thermal transfer rate between the inner contact surface and/or second thermal transfer features of the second zone and the warmer working fluid in fluid series.

In some embodiments, the thermal management device includes one or more mechanisms to change the flowrate(s) and/or flow volume(s) of working fluid through the first zone and the second zone of the internal volume. For example, the thermal management device includes a first inlet proximate to a first zone and a second inlet proximate to a second zone. The thermal management device includes an inlet valve on at least one of the first inlet and the second inlet to change the relative to flowrate and/or flow volume of working fluid through the inlets into the internal volume. For example, opening the inlet valve on the first inlet proximate to the first zone may result in an increased first flowrate and/or flow volume through the first zone relative to a second flowrate and/or flow volume through the second zone.

In some embodiments, the thermal management device includes a first outlet proximate to a first zone and a second outlet proximate to a second zone. The thermal management device includes an outlet valve on at least one of the first outlet and the second outlet to change the relative to flowrate and/or flow volume of working fluid through the outlet out of the internal volume. For example, opening the outlet valve on the first outlet proximate to the first zone may result in an increased first flowrate and/or flow volume through the first zone relative to a second flowrate and/or flow volume through the second zone. In some embodiments, the thermal management device includes valves on at least one inlet and at least one outlet to change the flowrate(s) and/or flow volume(s) of working fluid through the first zone and the second zone of the internal volume.

The thermal management device, in some embodiments, includes one or more mechanisms to change the relative flowrate(s) and/or flow volume(s) through the first zone and the second zone without changing a net flow through the internal volume (i.e., net flow through the inlet(s) and through the outlet(s)). In some embodiments, the thermal management device includes a proportioning device, such as a proportional three-way valve, that diverts a variable proportion of the working fluid flow toward the first zone and the second zone. For example, a proportioning device positioned before the inlets relative to the flow direction can selectively control a ratio of working fluid flow through the first inlet and through the second inlet. In some examples, a proportioning device positioned after the outlets relative to the flow direction can selectively control a ratio of working fluid flow through the first outlet and through the second outlet toward a heat exchanger or other heat exhaust device.

In some embodiments, a proportioning device is positioned at least partially inside the interval volume. A proportioning valve in the internal volume may direct a portion of the working fluid flow toward or away from the first zone and/or second zone. In some embodiments, the proportioning valve is a passive valve, such as a bi-metal valve (or other combination of materials) that changes position passively in response to a temperature of the working fluid, the first zone, the second zone, another portion of the thermal management device body, or combinations thereof. In a particular example, the first heat-generating component of the electronic package is a central processing unit (CPU), and the second heat-generating component of the electronic package is a graphics processing unit (GPU).

Depending on the computational task the CPU and GPU may experience different loads and generate different amounts of heat. During a GPU-intensive computational task, the second zone of the thermal management device experiences an increased quantity of heat and/or increased temperature. A difference in the coefficient of the thermal expansion (CTE) between materials in the proportioning valve causes at least a portion of the valve to move laterally when the temperature of the materials changes. The lateral movement of at least a portion of the valve changes the working fluid flow in the internal volume. In some embodiments, the valve moves to direct a greater proportion of the working fluid flow through the second zone when the valve increases in temperature due to the increase in temperature of the second zone.

In some embodiments, a thermal management feature is an active feature, such as a jet nozzle or spray nozzle that directs working fluid flow toward or directly impinging upon the contact wall or a contact surface of the internal volume. In some embodiments, a jet nozzle or spray nozzle directs working fluid flow toward or directly impinging upon any of the thermal transfer structures described herein. In some embodiments, the jet nozzle directs liquid phase working fluid into liquid phase working fluid to direct fluid flow through the internal volume. In some embodiments, a jet nozzle or spray nozzle directs liquid phase working fluid into a portion of the internal volume including a gas (e.g., a gas phase working fluid or inert gas).

For example, the internal volume of the thermal management device may include a headspace of gas that allows space for the vaporization of a dual-phase working fluid. A spray nozzle, in some embodiments, disperses a plurality of droplets of liquid working fluid through the gas phase to transfer heat between the gas and the droplets. In some embodiments, the plurality of droplets directly impinge upon a contact wall or a contact surface of the internal volume to receive heat from the contact wall or contact surface. In some embodiments, plurality of droplets directly impinge upon one or more thermal transfer structures, such as pin fins, described herein to receive heat from the thermal transfer structures.

In some embodiments, the internal volume is at least partially defined by a top surface of a heat-generating component. For example, the body of the thermal management device may include a window or other opening in a contact wall that complementarily mates with the heat-generating component such that a top surface of the heat-generating component is at least a portion of an inner contact surface of the internal volume. In some embodiments, the working fluid in the internal volume is positioned in direct contact with the top surface of the heat-generating component. Direct contact between the top surface and the working fluid removes interfaces relative to a conventional thermal management device and may increase thermal transfer efficiency between the heat-generating component and the working fluid.

In some embodiments, the jet nozzles and/or spray nozzles have different nozzle velocity and/or nozzle flow volumes. For example, direct impingement of a fluid jet from a jet nozzle can erode a top surface of a heat-generating component, while the same fluid jet of working fluid erodes a contact wall of the body of the thermal management device at a different rate. In at least one embodiment, a first nozzle and a second nozzle have the same flow volume therethrough (e.g., milliliters per minute) while the first nozzle has a different flow velocity of the working fluid than the second nozzle. The mass of working fluid able to receive heat from the heat-generating component may be substantially equal, while the difference in flow velocity reduces the erosion relative to a faster flow velocity.

As described herein, the jet nozzle and/or spray nozzle, in some embodiments, directs working fluid flow toward a top surface of a heat-generating component, and, in some embodiments, directs working fluid flow at a thermal transfer structure of the thermal management device. In some embodiments, the heat-generating component has thermal transfer structures integrally formed with the top surface to increase a surface area of the top surface.

In some examples, a thermal transfer structure is integrally formed with the top surface by additive manufacturing. For example, one or more pins, fins, or other thermal transfer structures may be formed through the application and/or epitaxial growth of material on a top surface of the heat-generating component. In some embodiments, at least a portion of a thermal transfer structure is above a portion of the top surface of the heat-generating component. In some examples, a thermal transfer structure is integrally formed with the top surface by substrative manufacturing. For example, one or more pins, fins, or other thermal transfer structures may be formed through the removal of material from the top surface of the heat-generating component such as by machining, ion etching, chemical etching, or other removal techniques to create channels, recesses, or voids in the top surface. In some embodiments, at least a portion of a thermal transfer structure is above a below of the top surface of the heat-generating component.

In at least one embodiment, a thermal management device according to the present disclosure has a hybrid design with direct contact between working fluid and a top surface of at least one heat-generating component in a first zone while a contact wall (and, optionally, TIM) thermally couples a second heat-generating component to a second zone.

While embodiments of thermal management devices have been described herein with a working fluid in an internal volume, in some embodiments, the internal volume is divided into at least a first portion and a second portion. The first portion of the internal volume and second portion of the internal volume are discrete fluid volumes between which a first portion of the working fluid in the first portion of the internal volume does not enter the second portion of the internal volume, and vice versa. In some embodiments, the first portion and second portion share the working fluid that circulates through the thermal management device. For example, the first portion of the working fluid enters the first portion of the internal volume through a first inlet and exits the first portion of the internal volume through a first outlet, while the second portion of the working fluid enters the second portion of the internal volume through a second inlet and exits the second portion of the internal volume through a second outlet. In some embodiments, a valve on one or more of the inlets and/or outlets can allow the adjustments to the flowrates and/or flow volumes through the first portion and second portion of the internal volume.

In some embodiments, the first outlet is connected to a heat exchanger, condenser, compressor, or other device for exhausting heat from the working fluid, and the second outlet is connected to the same heat exchanger, condenser, compressor, or other device for exhausting heat from the working fluid. The working fluid then circulates from the heat exchanger, condenser, compressor, or other device for exhausting heat from the working fluid to the inlets.

In some embodiments, the first portion of the internal volume and the second portion of the internal volume of the thermal management device are part of discrete fluid loops, in which a first working fluid of the first portion and a second working fluid of the second portion are not shared and/or do not mix inside the internal volume or at any other point. For example, the heat-generating components of the electronic package may have different maximum temperatures, and different working fluids are appropriate for the temperatures experienced in the first zone (associated with a first heat-generating component) in the first portion and for the temperatures experienced in the second zone (associated with a second heat-generating component) in the second portion.

Discrete fluid loops can allow for different working fluids, such as a single-phase working fluid in the first zone and a dual-phase working fluid in the second zone. In some embodiments, the first working fluid has a higher viscosity, limiting the ability of the first working fluid to flow through spray nozzles, while a second working fluid has a low viscosity, allowing the second working fluid to be sprayed through a spray nozzle. In some embodiments, the first zone includes a top surface of the heat-generating component, which is susceptible to reaction with a particular solvent, and a second working fluid used in the second zone (which is bounded by the contact wall) includes the solvent.

The present disclosure relates to systems and methods for liquid cooling of a multicomponent package according to at least the examples provided in the sections below:
Clause 1. A thermal management device comprising: a body including: an internal volume configured to receive a working fluid, and an inner contact surface configured to transfer heat from a heat-generating component to the internal volume; a first zone of the internal volume including a first thermal management feature; and a second zone of the internal volume including a second thermal management feature different from the first thermal management feature.
Clause 2. The thermal management device of clause 1, wherein the first thermal management feature is a thermal transfer structure.
Clause 3. The thermal management device of clause 1, wherein the first thermal management feature is a nozzle.
Clause 4. The thermal management device of clause 1, wherein the first zone and the second zone are in fluid parallel to one another.
Clause 5. The thermal management device of clause 1, wherein the first zone and the second zone are in fluid series to one another.
Clause 6. The thermal management device of clause 1, wherein the inner contact surface is a contact surface of a contact wall including a continuous heat spreader.
Clause 7. The thermal management device of clause 1, wherein the inner contact surface is at least partially integrally formed with a die surface.
Clause 8. The thermal management device of clause 1, wherein the working fluid is a first working fluid in the first zone, and further comprising a second working fluid in the second zone.
Clause 9. The thermal management device of clause 1, wherein the working fluid is a single-phase working fluid.
Clause 10. The thermal management device of clause 1, wherein the working fluid is a dual-phase working fluid.
Clause 11. The thermal management device of clause 1, further comprising a valve configured to change a working fluid flow in at least the first zone.
Clause 12. The thermal management device of clause 11, wherein the valve is a passive valve.
Clause 13. The thermal management device of clause 12, wherein the valve includes a plurality of materials with different coefficients of thermal expansion.
Clause 14. A thermal management device comprising: a body including: an internal volume configured to receive a working fluid, at least one inlet to the internal volume, at least one outlet from the internal volume, a valve configured to change a working fluid flow in the internal volume, and an inner contact surface configured to transfer heat from a heat-generating component to the internal volume; a first zone of the internal volume including a first thermal management feature; and a second zone of the internal volume including a second thermal management feature different from the first thermal management feature.
Clause 15. The thermal management device of clause 14, wherein the valve is an inlet valve configured to change a flowrate of the working fluid through the first zone.
Clause 16. The thermal management device of clause 14, wherein the valve is an outlet valve configured to change a flowrate of the working fluid through the first zone.
Clause 17. The thermal management device of clause 14, wherein the first zone is in a first portion of the internal volume and the second zone is in a second portion of the internal volume, wherein the first portion and second portion are discrete fluid volumes from one another.
Clause 18. The thermal management device of clause 17, wherein the at least one inlet is a first inlet and the body further includes a second inlet.
Clause 19. The thermal management device of clause 17, wherein the at least one outlet is a first outlet and the body further includes a second outlet.
Clause 20. A thermal management device comprising: a body including: an internal volume, a first inlet to a first portion of the internal volume configured to receive a first working fluid, a second inlet to a second portion of the internal volume configured to receive a second working fluid, a first outlet from the first portion of the internal volume, a second outlet from the second portion of the internal volume, and an inner contact surface configured to transfer heat from a heat-generating component to the internal volume; a first zone in the first portion of the internal volume including a first thermal management feature; and a second zone in the second portion of the internal volume including a second thermal management feature different from the first thermal management feature.

The articles "a," "an," and "the" are intended to mean that there are one or more of the elements in the preceding descriptions. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. For example, any element described in relation to an embodiment herein may be combinable with any element of any other embodiment described herein. Numbers, percentages, ratios, or other values stated herein are intended to include that value, and also other values that are "about" or "approximately" the stated value, as would be appreciated by one of ordinary skill in the art encompassed by embodiments of the present disclosure. A stated value should therefore be interpreted broadly enough to encompass values that are at least close enough to the stated value to perform a desired function or achieve a desired result. The stated values include at least the variation to be expected in a suitable manufacturing or production process, and may include values that are within 5%, within 1%, within 0.1%, or within 0.01% of a stated value.

A person having ordinary skill in the art should realize in view of the present disclosure that equivalent constructions do not depart from the spirit and scope of the present disclosure, and that various changes, substitutions, and alterations may be made to embodiments disclosed herein without departing from the spirit and scope of the present disclosure. Equivalent constructions, including functional "means-plus-function" clauses are intended to cover the structures described herein as performing the recited function, including both structural equivalents that operate in the same manner, and equivalent structures that provide the same function. It is the express intention of the applicant not to invoke means-plus-function or other functional claiming for any claim except for those in which the words 'means for' appear together with an associated function. Each addition, deletion, and modification to the embodiments that falls within the meaning and scope of the claims is to be embraced by the claims.

It should be understood that any directions or reference frames in the preceding description are merely relative directions or movements. For example, any references to "front" and "back" or "top" and "bottom" or "left" and "right" are merely descriptive of the relative position or movement of the related elements.

The described embodiments are to be considered as illustrative and not restrictive. The scope of the disclosure is, therefore, indicated by the appended claims rather than by the foregoing description. Changes that come within the meaning and range of equivalency of the claims are to be embraced within their scope.

## Claims

1. A thermal management device comprising:
a body (306) including:
an internal volume (308) configured to receive a working fluid, and
an inner contact surface (320) configured to transfer heat from a heat-generating component to the internal volume;
a first zone (326-1) of the internal volume including a first thermal management feature (328-1); and
a second zone (326-2) of the internal volume including a second thermal management feature (328-2) different from the first thermal management feature.

2. The thermal management device of claim 1, wherein the first thermal management feature is a thermal transfer structure (228).

3. The thermal management device of claim 1, wherein the first thermal management feature is a nozzle (538).

4. The thermal management device of any preceding claim, wherein the first zone (426-1) and the second zone (426-2) are in fluid parallel to one another.

5. The thermal management device of any of claims 1 to 3, wherein the first zone (326-1) and the second zone (326-2) are in fluid series to one another.

6. The thermal management device of any preceding claim, wherein the inner contact surface is a contact surface of a contact wall (316) including a continuous heat spreader.

7. The thermal management device of any of claims 1 to 5, wherein the inner contact surface (620) is at least partially integrally formed with a die surface (624).

8. The thermal management device of any preceding claim, wherein the working fluid is a first working fluid (810-1) in the first zone, and further comprising a second working fluid (810-2) in the second zone.

9. The thermal management device of any preceding claim, wherein the working fluid is a single-phase working fluid.

10. The thermal management device of any preceding claim, wherein the working fluid is a dual-phase working fluid.

11. The thermal management device of any preceding claim, further comprising a valve (430) configured to change a working fluid flow in at least the first zone.

12. The thermal management device of claim 11, wherein the valve is a passive valve.

13. The thermal management device of claim 12, wherein the valve (436) includes a plurality of materials with different coefficients of thermal expansion.

14. The thermal management device of any preceding claim, further comprising: at least one inlet (412) to the internal volume, and at least one outlet (414) from the internal volume.

15. The thermal management device of any preceding claim, wherein the first zone is in a first portion (746-1) of the internal volume and the second zone is in a second portion (746-2) of the internal volume, wherein the first portion and second portion are discrete fluid volumes from one another.
